# EUROPEAN PATENT APPLICATION

(11) **EP 1 796 087 A2**
(43) Date of publication of application: **13.06.2007**
(21) Application number: 06124102.2
(22) Date of filing: 15.11.2006
(51) Int. Cl.: G11B 7/24, G11B 7/26, H01L 29/73, H01L 29/786

(54) **Light scattering layer for electronic device comprising nano-particles, stacked structure comprising light scattering layer for thin film transistor, and methods of forming the same**

(30) Priority: 08.12.2005 KR 20050119474; 04.04.2006 KR 20060030508
(71) Applicant: Electronics and Telecommunications Research Institute, Daejeon-city (KR)
(72) Inventor: Kim, Sang Hyeob, Daejeon-city (KR)
(74) Representative: Betten & Resch

(57) **Abstract**

A light scattering layer for an electronic device comprising nano-particles, a junction structure for a thin film transistor comprising the light scattering layer, and methods of forming the same are provided. The light scattering layer for the electronic device comprises a carbide-semimetal or a carbide-metal comprising nano-particles comprising Si or a metal. In the junction structure for a thin film transistor according to an embodiment of the present invention, the light scattering layer is interposed between a first protective layer and a second protective layer comprising (ZnS)₁₋ₓ(SiC)ₓ, W₁₋ₓCₓ, Ta₁₋ₓCₓ, and Mo₁₋ₓCₓ, wherein 0 < x < 1. First and second capping layers comprising M_{1-y}((ZnS)₁₋ₓ(SiC)ₓ)_{y}, M_{1-y}(W₁₋ₓCₓ)_{y}, M_{1-y}(Ta₁₋ₓCₓ)_{y}, and M_{1-y}(Mo₁₋ₓCₓ)_{y}, wherein 0 < x < 1, 0 < y < 1, and M is Si, Ta, W or Mo, may be interposed between the first protective layer and the light scattering layer, and between the light scattering layer and the second protective layer, respectively. The layers are sequentially formed in-situ, without breaking a vacuum state after the process of forming each layer is performed.

## Description

### CROSS-REFERENCE TO RELATED PATENT APPLICATION

This application claims the benefits of Korean Patent Application No. 10-2005-0119474, filed on December 8, 2005, and Korean Patent Application No. 10-2006-0030508, filed on April 4, 2006, in the Korean Intellectual Property Office, the disclosures of which are incorporated herein in its entirety by reference.

### BACKGROUND OF THE INVENTION

### 1. Field of the Invention

The present invention relates to a light scattering layer for an electronic device, an electric junction structure including the light scattering layer, and methods of forming the same, and more particularly, to a light scattering layer for an electronic device comprising nano-particles, a junction structure for a thin film transistor consisting of a protective layer-a light scattering layer-a protective layer structure, and methods of forming the same.

### 2. Description of the Related Art

Conventional thin film transistor devices use a technique of amplifying signals within optical fibers. Much research has been conducted regarding signal amplification within optical fibers using an optical nonlinear effect. However, to increase amplification sensitivity, it is necessary to widen and lengthen the optical fiber, therefore the size of an amplifier body, containing the optical fiber, is increased. This is severely disadvantageous when manufacturing electronic devices which place a large emphasis on miniaturization.

In addition, various techniques of applying PNP-NPN junctions and Josephsen junctions in the field of electronic circuits have been developed over the past decades. PNP-NPN junctions are used with bipolar transistors and amplify a signal using two carriers such as electrons and holes. Josephsen junctions are used with superconductors. Techniques using PNP-NPN junctions and Josephsen junctions are mainly found in the field of electronic circuits. Of these techniques, Josephsen junction manufacture and application in electronic circuits are most common. Josephsen junctions use a low temperature superconductor, Nb, which has a super conductive transition temperature Tc of 9.2K and a high temperature superconductor, Y₁Ba₂Cu₃O₇₋ₓ(YBCO), which has a super conductive transition temperature Tc of 93K. In the high temperature superconductor, the YBCO thin film, a super conductive transition occurs above the boiling point of liquid nitrogen. Since the energy gap of the YBCO thin film is larger than in the lower temperature superconductor, the YBCO thin film is favorably applicable to a high-speed electronic circuit. However, since the YBCO thin film is sensitive to oxygen doping due to its composite oxide structure, it is difficult to consistently manufacture a number of junctions and it is also difficult to use in manufacture of an integrated circuit.

A three-layer junction structure using the YBCO has been suggested as an example of a way to use a Josephsen junction using a conventional junction technique. This conventional technique forms the Josephsen junction in a three-layer structure, by depositing a lower YBCO thin film, reforming the surface of the YBCO thin film using an Ar plasma, and continuously depositing an upper YBCO thin film in a vacuum. However, it is difficult to reproduce regular junctions in a Josephsen junction obtained from this conventional technique, due to the sensitivity of composite oxide materials of the Josephsen junction, and thus, it is difficult to apply it to an integrated electronic circuit.

### SUMMARY OF THE INVENTION

The present invention provides a light scattering layer for an electronic device, which has an improved regularity and reproducibility.

The present invention also provides a method of forming a light scattering layer for an electronic device which has an improved regularity and reproducibility.

The present invention also provides a junction structure for a thin film transistor including a light scattering layer for an electronic device which has an improved regularity and reproducibility, can be regularly manufactured at an appropriate level for use in an integrated electronic circuit, amplifies a signal by light scattering, and is straightforward to use to manufacture a miniaturized and integrated electronic device.

The present invention also provides a method of forming a junction structure for a thin film transistor including a light scattering layer for an electronic device which is straightforward to use to manufacture a miniaturized and integrated electronic device, the method being simple.

According to an aspect of the present invention, there is provided a light scattering layer for an electronic device, comprising carbide-semimetal or carbide-metal including nano-particles consisting of Si or metal. The nano-particles may include Si, Ta, W or Mo. The light scattering layer may include a material represented as (MC)₁₋ₓMₓ, (wherein M is Si, Ta, W or Mo, and 0 < x < 1).

According to another aspect of the present invention, there is provided a method of forming a light scattering layer for an electronic device, comprising: forming, on a substrate, a layer represented as (MC)₁₋ₓMₓ, (wherein M is Si, Ta, W or Mo, and 0 < x < 1); and applying heat-treatment to the layer so that nano-particles including M are generated within the layer.

The thermal treatment may be performed below a temperature of 100~1000°C, and laser power may be applied to the layer while the thermal treatment is performed.

According to another aspect of the present invention, there is provided a junction structure for a thin film transistor, comprising: a first protective layer including one carbide selected from the group consisting of (ZnS)₁₋ₓ(SiC)ₓ, W₁₋ₓCₓ, Ta₁₋ₓCₓ and Mo₁₋ₓCₓ (wherein, 0 < x < 1); a light scattering layer formed on the first protective layer and including carbide-semimetal or carbide-metal including nano-particles consisting of Si or metal; and a second protective layer formed on the light scattering layer and including one carbide selected from the group consisting of (ZnS)₁₋ₓ(SiC)ₓ, W₁₋ₓCₓ, Ta₁₋ₓCₓ, and Mo₁₋ₓCₓ (wherein, 0 < x < 1).

The junction structure for a thin film transistor may further comprise a first capping layer formed between the first protective layer and the light scattering layer and including a carbide layer doped with silicone or metal; and a second capping layer formed between the light scattering layer and the second protective layer and including a carbide layer doped with silicone or metal.

The first capping layer and the second capping layer may include one doped carbide selected from the group consisting of M_{1-y}((ZnS)₁₋ₓ(SiC)ₓ)_{y}, M_{1-y}(W₁₋ₓCₓ)_{y}, M_{1-y}(Ta₁₋ₓCₓ)_{y}, and M_{1-y}(Mo₁₋ₓCₓ)_{y} (wherein, 0 < x < 1, 0 < y < 1, and M is Si, Ta, W or Mo), respectively.

According to another aspect of the present invention, there is provided a method of forming a junction structure for a thin film transistor, comprising: forming, on a substrate, a first protective layer including one carbide selected from the group consisting of (ZnS)₁₋ₓ(SiC)ₓ, W₁₋ₓCₓ, Ta₁₋ₓCₓ, and Mo₁₋ₓCₓ (wherein, 0 < x < 1); forming, on the first protective layer, a light scattering layer including (MC)₁₋ₓMₓ, (wherein, M is Si, Ta, W or Mo and 0 < x < 1); applying thermal treatment to the light scattering layer so that nano-particles including M are generated inside the light scattering layer; and forming, on the light scattering layer, a second protective layer including one carbide selected from the group consisting of (ZnS)₁₋ₓ(SiC)ₓ, W₁₋ₓCₓ, Ta₁₋ₓCₓ, and Mo₁₋ₓCₓ (wherein, 0 < x < 1).

The method of forming a junction structure for a thin film transistor may further comprise: forming, on the first protective layer, a first capping layer including a carbide layer doped with silicone or metal, before forming the light scattering layer. In addition, the method of forming a junction structure for a thin film transistor may further comprise: forming, on the light scattering layer, a second capping layer including a carbide layer doped with silicone or metal, before applying the thermal treatment to the light scattering layer.

The first protective layer, the first capping layer, the light scattering layer, and the second capping layer are sequentially formed in-situ after a preceding process of forming each layer, without breaking a vacuum state in the preceding process.

In accordance with the present invention, a miniaturized and integrated electronic device is realized by using the light scattering layer including the carbide-semimetal or carbide-metal, i.e., (MC)₁₋ₓMₓ (wherein, M is Si, Ta, W or Mo, and 0 < x < 1). For this purpose, a three-layer structure is formed by including the protective layer-light scattering layer-protective layer, or a five-layer structure is formed by including the protective layer-capping layer-light scattering layer-capping layer-protective layer are formed, thereby making it easy to generate the nano-particles in the light scattering layer and preventing an irregular junction which likely occurs in each interface of the protective layer-capping layer-light scattering layer. In addition, when a light-scattering thin film transistor is manufactured using the junction structure including the light scattering layer, a signal amplification effect of the thin film transistor is greater by about 60 or more times that of an existing bipolar transistor, and a miniaturized and integrated electronic circuit can be manufactured by remarkably reducing the total thickness of the junction structure.

### BRIEF DESCRIPTION OF THE DRAWINGS

The above and other features and advantages of the present invention will become more apparent by describing in detail exemplary embodiments thereof with reference to the attached drawings in which:

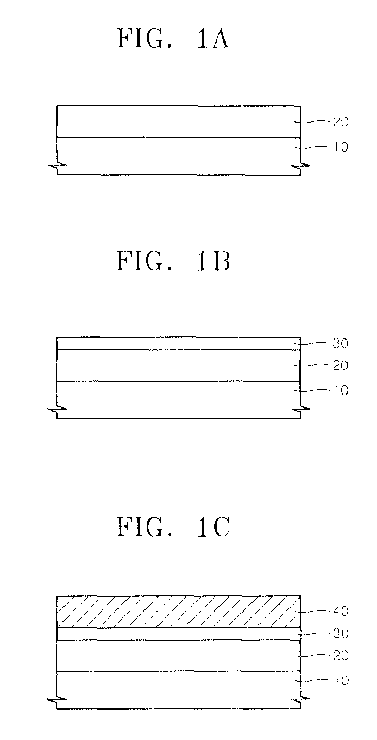

FIGS. 1A through 1G are sectional views illustrating, by sequential processes, a method of forming a junction structure for a thin film transistor including a light scattering layer for an electronic device in accordance with an embodiment of the present invention.

### DETAILED DESCRIPTION OF THE INVENTION

The present invention will now be described more fully hereinafter with reference to the accompanying drawings, in which preferred embodiments of the invention are shown.

FIGS. 1A through 1G are cross-sectional views illustrating a method of forming a junction structure for a thin film transistor comprising a light scattering layer which can be used in an electronic device according to an embodiment of the present invention.

Referring to FIG. 1A, a substrate 10 comprises any one selected from the group consisting of GaN, Al₂O₃, SiC, ZnO, LiAlO₂, LiGaO₂, MgO, and SrTiO₃, or a combination thereof.

A first protective layer 20 is formed on the substrate 10. The first protective layer 20 comprises a carbide and is formed to a thickness of about 10~300nm. The first protective layer 20 comprises at least one carbide selected from the group consisting of (ZnS)₁₋ₓ(SiC)ₓ, W₁₋ₓCₓ, Ta₁₋ₓCₓ, and Mo₁₋ₓCₓ (wherein, 0 < x < 1, respectively).

Referring to FIG. 1B, a first capping layer 30 is formed on the first protective layer 20.

The first capping layer 30 includes a carbide layer doped with Si or metal and is formed to a thickness of about 0.5~2nm. For example, the first capping layer 30 comprises at least one doped carbide selected from the group consisting of M_{1-y}((ZnS)₁₋ₓ(SiC)ₓ)_{y}, M_{1-y}(W₁₋ₓCₓ)_{y}. M_{1-y}(Ta₁₋ₓCₓ)_{y}, and M_{1-y}(Mo₁₋ₓCₓ)_{y} (wherein, 0 < x < 1, 0 < y < 1, and M is Si, Ta, W or Mo).

Referring to FIG. 1C, a light scattering layer 40 is formed on the first capping layer 30. The light scattering layer 40 includes carbide-semimetal or carbide-metal, i.e., (MC)₁₋ₓMₓ (wherein, M is Si, Ta, W or Mo, and 0 < x < 1).

The materials forming the first protective layer 20 and the first capping layer 30, (ZnS)₁₋ₓ(SiC)ₓ, W₁₋ₓCₓ, Ta₁₋ₓCₓ, and Mo₁₋ₓCₓ, and the materials forming the light scattering layer 40, (MC)₁₋ₓMₓ, have the same crystal structure, and have almost identical lattice constants, ensuring that the epitaxial growth of the light scattering layer 40 is straightforward. Furthermore, atoms of the M forming the light scattering layer 40, i.e., Si, Ta, W and Mo, have a very short diffusion distance, so that it is possible to generate nano-scale light scattering particles using laser light of low power.

The light scattering layer 40 is formed to a thickness of about 2~50nm.

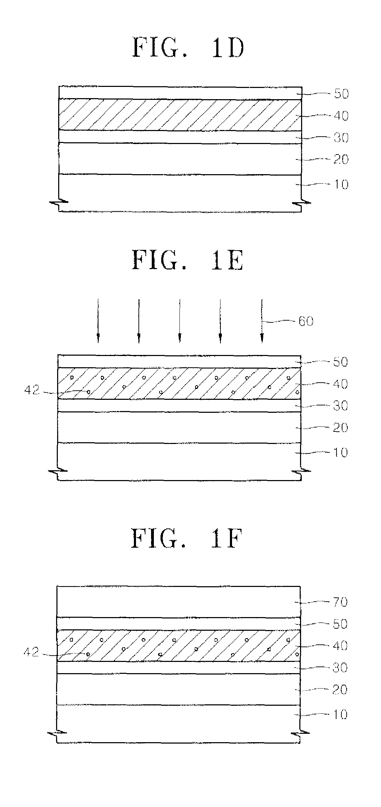

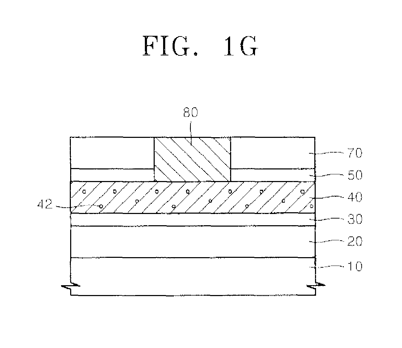

Referring to FIG. 1D, a second capping layer 50 is formed on the light scattering layer 40, in the same manner as the method of forming the first capping layer 30, referred to in FIG. 1B. The second capping layer 50 is formed to a thickness of about 0.5~2nm. The second capping layer comprises at least one doped carbide selected from the group consisting of M_{1-y}((ZnS)₁₋ₓ(SiC)ₓ)_{y}, M_{1-y}(W₁₋ₓCₓ)_{y}, M_{1-y}(Ta₁₋ₓCₓ)_{y}, and M_{1-y}(Mo₁₋ₓCₓ)_{y} (wherein, 0 < x < 1, 0 < y < 1, and M is Si, Ta, W or Mo).

The first protective layer 20, the first capping layer 30, the light scattering layer 40, and the second capping layer 50, which are formed as described in reference to FIGS. 1A through 1D, are formed by methods such as sputtering, pulsed laser deposition, chemical vapor deposition, dual ion beam deposition, e-beam evaporation, or spin coating. To obtain epitaxial multi layers in the deposition process used in forming the first protective layer 20, the first capping layer 30, the light scattering layer 40 and the second capping layer 50, a processing temperature of between 25~400°C is used.

Furthermore, the first protective layer 20, the first capping layer 30, the light scattering layer 40 and the second capping layer 50 are sequentially deposited in-situ, without breaking a vacuum state in each preceding process. The in-situ method of forming the first protective layer 20, the first capping layer 30, the light scattering layer 40 and the second capping layer 50 does not allow these layers to be exposed to air during their formation processes, thereby preventing junction irregularity caused by contamination and increasing reproducibility of junctions formed using this method. As a result, consistent junctions that can be used in integrated electronic circuits can be formed using a relatively straightforward method, without contamination and with good reproducibility.

Referring to FIG. 1E, thermal treatment 60 is applied to the resultant structure of FIG. D after the second capping layer 50 is formed, thereby generating nano-particles 42 in the light scattering layer 40 which are formed to scatter light. The nano-particles 42 have an average diameter of a few nanometers to several tens of nanometers, and comprise one material selected from the group of materials forming the light scattering layer 40, i.e., Si, Ta, W, and Mo.

The thermal treatment 60 is performed at a temperature of about 100~1000°C. When the thermal treatment 60 is performed, laser light having a power of about 1~20mW may be applied to the structure including the light scattering layer 40. Applying the laser light to the light scattering layer 40 accelerates the generation of the nano-particles 42, formed to scatter light.

Then a wiring circuit structure (not shown) is formed in a desired pattern by patterning the second capping layer 50, the light scattering layer 40 and the first capping layer 30 of the resultant structure of the thermal treatment 60. The patterning is performed by general photolithography processes and ion milling processes. The first protective layer 20 may also be patterned if necessary when the patterning process, to form the wiring circuit structure, is performed.

Referring to FIG. 1F, a second protective layer 70 is formed on the second capping layer 50 in the same manner as the method of forming the first protective layer 20 referred to in FIG. 1A. The second protective layer 70 is formed to a thickness of about 10~300nm. The second protective layer 70 comprises at least one carbide selected from the group consisting of (ZnS)₁₋ₓ(SiC)ₓ, W₁₋ₓCₓ, Ta₁₋ₓCₓ, and Mo₁₋ₓCₓ (wherein, 0 < x < 1, respectively). The second protective layer 70 is formed by a method of sputtering, pulsed laser deposition, chemical vapor deposition, dual ion beam deposition, e-beam evaporation or spin coating. When the deposition process is performed to form the second protective layer 70, a processing temperature of about 25~400°C is used.

Referring to FIG. 1G, parts of the second protective layer 70 and second capping layer 50 are removed in order to expose a part of an upper surface of the light scattering layer 40. Then, an electrode pad 80 is formed on the exposed part of the light scattering layer 40. The electrode pad 80 comprises, for example, Pt, Ag, Mg, In, Al, Au, Ag, W, Mo, Ta, Ti, Co, Ni, or Pd.

In the method of forming the junction structure for a thin film transistor including the light scattering layer which can be used in an electronic device according to an embodiment of the present invention, the processes of forming the first capping layer 30 and the second capping layer 50 of FIGS. 1B and 1D may be not performed.

As described above, the junction structure for a thin film transistor including the light scattering layer for an electronic device according to the present embodiment is a P-L-P junction formed using a junction structure of Protective layer (P)-Light scattering layer (L)-Protective layer (P) and using the light scattering layer 40 comprising a carbide-semimetal or a carbide-metal, i.e., (MC)₁₋ₓMₓ (wherein, M is Si, Ta, W or Mo, and 0 < x < 1). The P-L-P junction forming process is performed in-situ, and all layers are sequentially grown. Since the multiple layers are sequentially deposited in-situ, the layers exposed are prevented from being contaminated by air and thereby a more reproducible junction structure can be formed.

Furthermore, when a five-layer junction structure of protective layer-capping layer-light scattering layer-capping layer-protective layer is formed as illustrated in the processes referred to in FIGS. 1A through 1G, the nano-particies are more easily generated in the light scattering layer, thereby formation of an irregular junction, which is likely to be formed between the layers in the junction structure of protective layer-capping layer-light scattering layer, can be more easily prevented from being formed. This is because a stoichiometric layer is formed preventing a component irregularity between the protective layer and the capping layer. When a light scattering thin film transistor is manufactured using the junction structure as illustrated in FIG. 1G, a signal amplification effect thereof is stronger by about 60 or more times that of an existing bipolar transistor. Furthermore, since the total thickness of the junction structure is about ten nanometers to several hundreds of nanometers, it is possible to manufacture a miniaturized electronic circuit using the junction structure of the present invention.

In accordance with the present invention, a miniaturized and integrated electronic device is realized by using the light scattering layer comprising a carbide-semimetal or a carbide-metal, i.e., (MC)₁₋ₓMₓ (wherein, M is Si, Ta, W or Mo, and 0 < x < 1). In the light scattering layer including the carbide-semimetal or carbide-metal materials that generate nano-particies, an appropriate quantitative ratio of the materials can be easily made since the atoms of Si, Ta, W or Mo bond excellently with carbon. Also, a junction structure can be relatively easily realized since the layer has excellent regularity and reproducibility. In the method of manufacturing a three-layer junction structure of protective layer-light scattering layer-protective layer including the light scattering layer, each layer is sequentially grown in-situ, thereby preventing layers from being exposed to air and being contaminated and thus creating a junction manufacture with high reproducibility. Furthermore, the five-layer junction structure of protective layer-capping layer-light scattering layer-capping layer-protective layer makes it easier to generate nano-particles in the light scattering layer, and prevents irregular junctions being formed at each interface within the protective layer-capping layer-light scattering layer. This is because the stoichiometric layer can be formed preventing a component irregularity between the protective layer and capping layer. When the light scattering thin film transistor is manufactured using a junction structure including the light scattering layer according to an embodiment of the present invention, the signal amplification effect thereof is about 60 or more times stronger than that of an existing bipolar transistor. In addition, since the total thickness of the junction structure is about ten nanometers to several hundreds of nanometers, it is possible to manufacture a miniaturized and integrated electronic circuit.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A light scattering layer for an electronic device, comprising a layer comprising a carbide-semimetal or a carbide-metal comprising nano-particles comprising Si or a metal.

2. The light scattering layer of claim 1, wherein the nano-particles comprise Si, Ta, W or Mo.

3. The light scattering layer of claim 1, wherein the layer comprises a material represented by (MC)₁₋ₓMₓ, wherein M is Si, Ta, W or Mo, and 0 < x < 1.

4. A method of forming a light scattering layer for an electronic device, comprising:
forming a layer represented as (MC)₁₋ₓMₓ on a substrate, wherein M is Si, Ta, W or Mo, and 0 < x < 1; and
applying thermal treatment to the layer, thereby generating nana-particles comprising M in the light scattering layer.

5. The method of claim 4, wherein the thermal treatment is performed at a temperature of 100~1000°C.

6. The method of claim 4, wherein laser light is applied to the layer in a process of applying the thermal treatment.

7. The method of claim 6, wherein laser light having power of 1~20mW is applied in the process of performing the thermal treatment.

8. A junction structure for a thin film transistor, comprising:
a first protective layer comprising one carbide selected from the group consisting of (ZnS)₁₋ₓ(SiC)ₓ, W₁₋ₓCₓ, Ta₁₋ₓCₓ, and Mo₁₋ₓCₓ, wherein 0 < x < 1;
a light scattering layer formed on the first protective layer and comprising a carbide-semimetal or a carbide-metal including nano-particles comprising Si or a metal;
a second protective layer formed on the light scattering layer and comprising one carbide selected from the group consisting of (ZnS)₁₋ₓ(SiC)ₓ, W₁₋ₓCₓ, Ta₁₋ₓCₓ, and Mo₁₋ₓCₓ, wherein 0 < x < 1.

9. The junction structure of claim 8, further comprising:
a first capping layer formed between the first protective layer and the light scattering layer and comprising a carbide doped with silicone or metal; and
a second capping layer formed between the light scattering layer and the second protective layer and comprising a carbide doped with silicone or metal.

10. The junction structure of claim 9, wherein the first and second capping layers include one doped carbide selected from the group consisting of M_{1-y}((ZnS)₁₋ₓ(SiC)ₓ)_{y}, M_{1-y}(W₁₋ₓCₓ)_{y}, M_{1-y}(Ta₁₋ₓCₓ)_{y}, and M_{1-y}(Mo₁₋ₓCₓ)_{y}, wherein 0 < x < 1, 0 < y < 1, and M is Si, Ta, W or Mo.

11. The junction structure of claim 8 or 9, wherein the substrate comprises one material selected from the group consisting of GaN, Al₂O₃, SiC, ZnO, LiAlO₂, LiGaO₂, MgO, and SrTiO₃.

12. The juncion structure of one of claims 8 to 11, wherein the light scattering layer has a thickness of 2~50nm.

13. The junction structure of one of claims 8 to 12, wherein the first and second protective layers have a thickness of 10~300nm.

14. The junction structure of one of claims 9 to 13, wherein the first and second capping layers have a thickness of 0.5~2nm.

15. A method of forming a junction structure for a thin film transistor, comprising:
forming, on a substrate, a first protective layer comprising one carbide selected from the group consisting of (ZnS)₁₋ₓ(SiC)ₓ, W₁₋ₓCₓ, Ta₁₋ₓCₓ, and Mo₁₋ₓCₓ, wherein 0 < x < 1;
forming, on the first protective layer, a light scattering layer comprising (MC)₁₋ₓMₓ, wherein, M is Si, Ta, W or Mo, and 0 < x < 1;
applying thermal treatment to the light scattering layer, thereby generating nano-particles comprising M in the light scattering layer; and
forming, on the light scattering layer, a second protective layer comprising one carbide selected from the group consisting of (ZnS)₁₋ₓ(SiC)ₓ, W₁₋ₓCₓ, Ta₁₋ₓCₓ, and Mo₁₋ₓCₓ, wherein 0 < x < 1.

16. The method of claim 15, further comprising:
forming, on the first protective layer, a first capping layer comprising a carbide doped with silicone or metal, before the light scattering layer is formed; and
forming, on the light scattering layer, a second capping layer comprising a carbide doped with silicone or metal, before the thermal treatment is applied to the light scattering layer.

17. The method of claim 16, wherein the first protective layer, the first capping layer, the light scattering layer and the second capping layer are sequentially formed in-situ without breaking a vacuum state after the process of forming each layer is performed.

18. The method of claim 16 or 17, wherein the first protective layer, the first capping layer, the light scattering layer and the second capping layer are formed at a temperature of 25~400°C.
